# EUROPEAN PATENT APPLICATION

(11) **EP 2 675 154 A1**
(43) Date of publication of application: **18.12.2013**
(21) Application number: 12199429.7
(22) Date of filing: 27.12.2012
(51) Int. Cl.: H04N 5/64, H05K 9/00

(54) **Television reception apparatus, board module, and electronic apparatus**

(30) Priority: 15.06.2012 JP 2012135764
(71) Applicant: Kabushiki Kaisha Toshiba, Tokyo 105-8001 (JP)
(72) Inventor: Sakamoto, Noriaki, Tokyo, 105-8001 (JP); Kobayashi, Masahiro, Tokyo, 105-8001 (JP); Suzuki, Hajime, Tokyo, 105-8001 (JP)
(74) Representative: Henkel, Breuer & Partner

(57) **Abstract**

According to one embodiment, an electronic apparatus (10) includes a housing (11), a board (14) in the housing (11), an electrically conductive shield unit (33), a connector (95), and an extending portion (71). The housing (11) includes an opening (69). The electrically conductive shield unit (33) includes a first section (51) and a second section (52) intersecting the first section (51) at an end portion of the first section (51) and configured to be secured to the board (14). The connector is on the board (14), configured to be secured to the first section (51) of the shield unit (33), and exposed through the opening (69) of the housing (11). The extending portion (71) extends from the end portion of the first section (51) of the shield unit (33) and is configured to be secured to the board (14).

## Description

Embodiments described herein relate generally to a television reception apparatus, board module, and electronic apparatus.

A television reception apparatus comprises a tuner that selects radio signals of a target frequency. The tuner comprises a shield case configured to suppress interference by noise from other components, such as a liquid-crystal display. A circuit comprising various electronic components, such as a coil, is formed in the shield case.

There is known a so-called on-board tuner, as well as a tuner with the circuit formed in the shield case. In the on-board tuner, a circuit is formed in a main board on which other components, such as an MPU, are mounted. Further, a terminal for attachment of an antenna wire is mounted on the main board.

Devices such as the tuner described above in which the terminal is mounted on the board leave room for various improvements. For example, a junction between the terminal and board is expected to be reinforced.

A general architecture that implements the various features of the embodiments will now be described with reference to the drawings. The drawings and the associated descriptions are provided to illustrate the embodiments and not to limit the scope of the invention.
FIG. 1 is an exemplary perspective view showing a television according to a first embodiment;
FIG. 2 is an exemplary sectional view of the television of the first embodiment taken along line F2-F2 of FIG. 1;
FIG. 3 is an exemplary exploded perspective view showing a main board and tuner module of the first embodiment;
FIG. 4 is an exemplary plan view showing the main board and tuner module of the first embodiment;
FIG. 5 is an exemplary sectional view of the main board and tuner module of the first embodiment taken along line F5-F5 of FIG. 4;
FIG. 6 is an exemplary exploded perspective view showing a main board and tuner module according to a second embodiment;
FIG. 7 is an exemplary plan view showing the main board and tuner module of the second embodiment;
FIG. 8 is an exemplary exploded perspective view showing a main board and tuner module according to a third embodiment;
FIG. 9 is an exemplary perspective view showing a portable computer according to a fourth embodiment; and
FIG. 10 is an exemplary perspective view showing a main board according to a fifth embodiment.

Various embodiments will be described hereinafter with reference to the accompanying drawings.

In general, according to one embodiment, an electronic apparatus includes a housing, a board in the housing, an electrically conductive shield unit, a connector, and an extending portion. The housing includes an opening. The electrically conductive shield unit includes a first section and a second section intersecting the first section at an end portion of the first section and configured to be secured to the board. The connector is on the board, configured to be secured to the first section of the shield unit, and exposed through the opening of the housing. The extending portion extends from the end portion of the first section of the shield unit and is configured to be secured to the board.

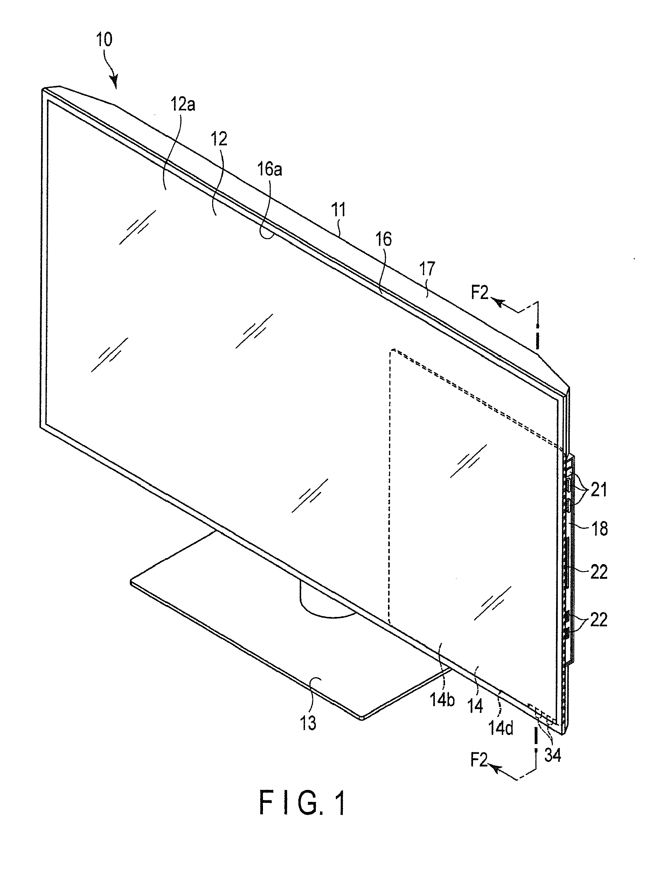

A first embodiment will now be described with reference to FIGS. 1 to 5. In this specification, the near or user side is defined as forward; the far side from the user as rearward, the user's left-hand side as leftward, the user's right-hand side as rightward, the upper side with respect to the user as upward, and the lower side with respect to the user as downward. Further, each element that can be expressed in different ways may sometimes be represented by one or more alternative examples of expressions. However, this neither denies that an element that is not given any alternative expression can be differently expressed, nor restricts other expressions that are not exemplified.

FIG. 1 is an exemplary perspective view showing a television reception apparatus (television) 10. The television 10 is an example of a television reception apparatus or electronic apparatus. As shown in FIG. 1, the television 10 comprises a housing 11, display module 12, pedestal 13, and main board 14. The display module 12 can be alternatively expressed as a panel, display unit, display device, or component. The main board 14 is an example of a board or board module and can be alternatively expressed as a component, module, circuit board, or motherboard. The television 10 may comprise a board called a sub-board or daughterboard.

The housing 11 is substantially rectangular. The housing 11 comprises front cover 16 that form the front surface of the housing 11, and rear cover 17 that form the rear surface of the housing 11. The rear cover 17 also partially forms side surfaces of the housing 11.

A control unit 18 is disposed on one of the side surfaces of the housing 11. The control unit 18 comprises buttons 21 and holes 22. The buttons 21 are used to turn on the television 10 or change the channel. For example, cards and cable terminals are passed through the holes 22.

The pedestal 13 is removably connected to, for example, the rear surface of the housing 11. The pedestal 13 pivotably supports the housing 11. Alternatively, the housing 11 may be hung on a wall without the use of the pedestal 13, for example.

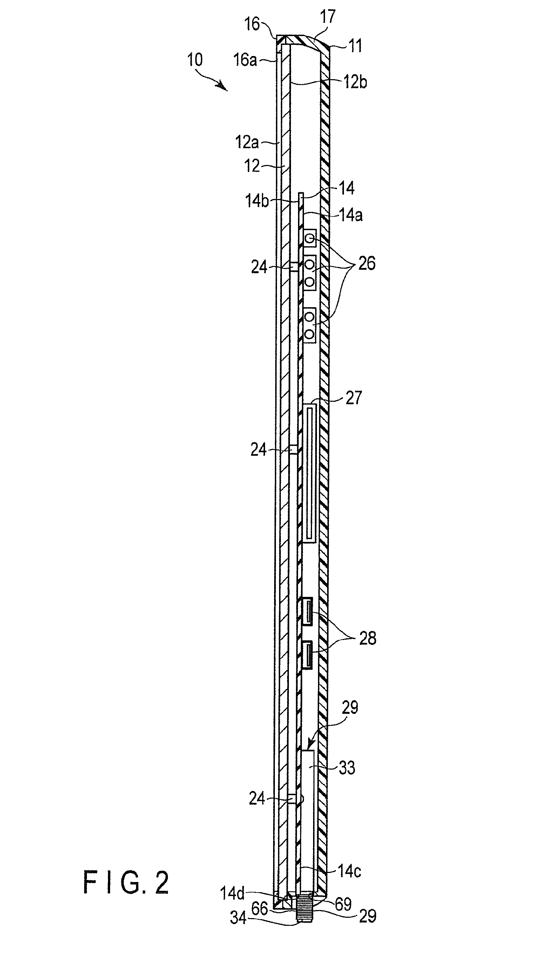

FIG. 2 is an exemplary sectional view of the television 10 taken along line F2-F2 of FIG. 1. The pedestal 13 is not shown in FIG. 2 for ease of illustration. As shown in FIG. 2, the display module 12 and main board 14 are accommodated in the housing 11.

The display module 12 is, for example, a liquid-crystal display. The display module 12 is not limited to the liquid-crystal display and may be another component configured to display images, such as an organic electroluminescent (EL) display.

The display module 12 is a rectangular structure secured to, for example, the front cover 16. The display module 12 comprises a display surface 12a configured to display images. In this specification, images include still and moving images and monochromatic images. The display surface 12a is exposed to the outside of the housing 11 through a rectangular opening 16a in the front cover 16.

The main board 14 is substantially rectangular. The main board 14 is attached to a rear surface 12b of the display module 12 by means of spacers 24. The rear surface 12b is located opposite the display surface 12a.

The main board 14 comprises a first surface 14a and second surface 14b. The second surface 14b is located opposite the first surface 14a and faces the rear surface 12b of the display module 12.

Various electronic components, such as switch modules 26, card slot 27, connectors 28, tuner module 29, and MPU, are disposed on the first surface 14a. The tuner module 29 is an example of a module unit, tuner, or connector and can be alternatively expressed as a tuner, component, or unit. These various electronic components may be disposed on some other part of the main board 14 than the first surface 14a, such as the second surface 14b.

The switch modules 26 correspond individually to the buttons 21 of FIG. 1. The card slot 27 and connectors 28 correspond individually to the holes 22 of FIG. 1.

The tuner module 29 is disposed at a lower end portion 14c of the main board 14. The lower end portion 14c is an area near a lower edge 14d of the main board 14. The tuner module 29 may be disposed in some other place than the lower end portion 14c of the main board 14.

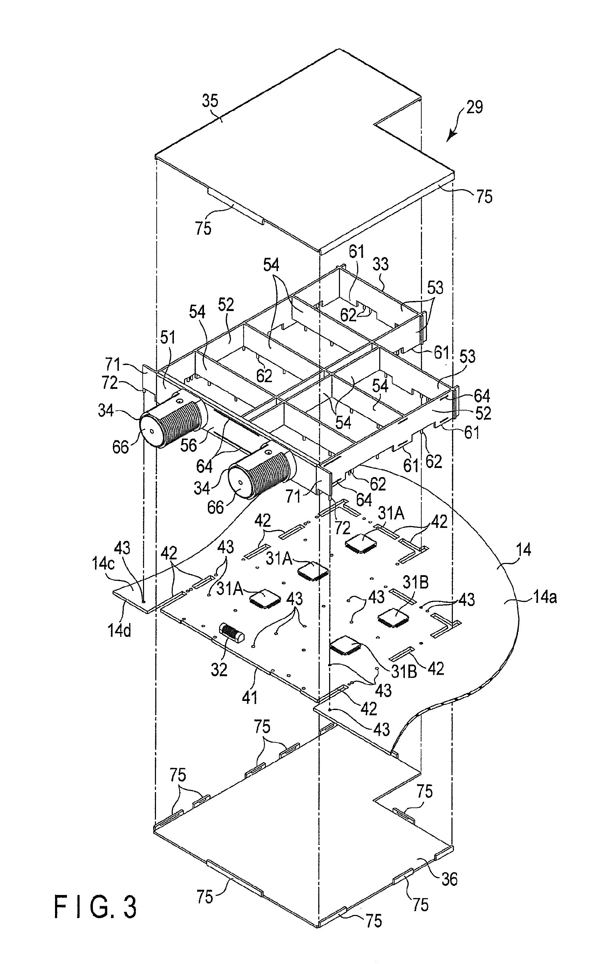

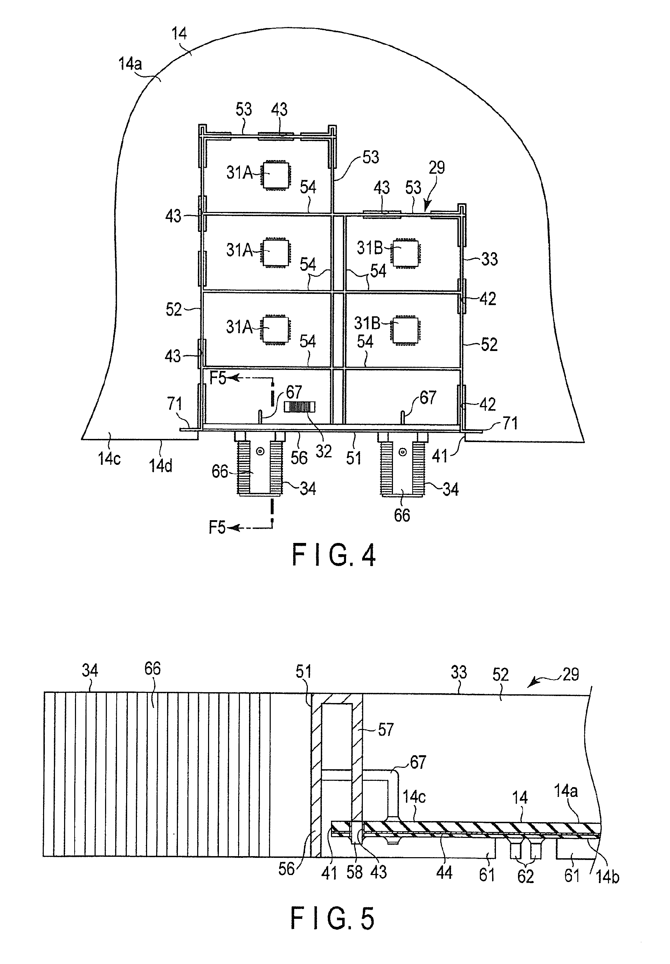

FIG. 3 is an exemplary exploded perspective view showing a part of the main board 14 and the tuner module 29. FIG. 4 is an exemplary plan view showing a part of the main board 14 and the tuner module 29 with some of its components removed. FIG. 5 is an exemplary partial sectional view of the main board 14 and tuner module 29 with some of its components removed taken along line F5-F5 of FIG. 4.

As shown in FIG. 3, the tuner module 29 comprises a plurality of chips 31A and 31B, coil 32, shield unit 33, two terminal portions 34, first shield cover 35, and second shield cover 36. Chips 31A and 31B and the coil 32 are an example of a circuit unit. The shield unit 33 can be alternatively expressed as a component, wall portion, frame portion, or partition wall. The terminal portions 34 can be alternatively expressed as plugs, plug connectors, or junctions.

Chips 31A and 31B and the coil 32 are individually mounted on the first surface 14a of the main board 14. They are individually electrically connected to a trace pattern on the first surface 14a. This trace pattern, chips 31A and 31B, and the coil 32 form a tuner circuit. Chips 31A are tuned to, for example, radio signals of an arbitrary frequency for terrestrial digital broadcasting. Chips 31B are tuned to, for example, radio signals of an arbitrary frequency for satellite or communication satellite broadcasting. The tuner circuit that comprises chips 31A and 31B, the coil 32, and the trace pattern is connected to another trace pattern on the main board 14.

The main board 14 comprises a recess 41, slits 42, and insertion holes 43. As shown in FIG. 5, moreover, a ground layer 44 is disposed inside the main board 14. The ground layer 44 is an example of a ground portion.

As shown in FIG. 3, the recess 41 is disposed at the lower edge 14d of the main board 14. Thus, an edge portion that defines the recess 41 is located deeper inside the main board 14 than the lower edge 14d. The slits 42 are arranged around chips 31A and 31B and the coil 32.

As shown in FIG. 5, the insertion holes 43 are electrically connected to the ground layer 44. Thus, an electrical conductor connected to the insertion holes 43 is grounded by the ground layer 44. The insertion holes 43 are not limited to such round holes as shown in FIG. 3 and may be holes of another shape, such as rectangular.

As shown in FIG. 3, the shield unit 33 comprises a first section 51, a pair of second sections 52, third sections 53, and fourth sections 54. The first to fourth sections 51 to 54 can be alternatively expressed as, for example, wall portions, partition walls, or shields.

The first to fourth sections 51 to 54 are formed of rectangular metal plates, individually. Thus, the shield unit 33 is electrically conductive. The first to fourth sections 51 to 54 are combined by various means, such as welding, crimping, and adhesive bonding, and are formed in a lattice, as shown in FIG. 3.

As shown in FIG. 5, the first section 51 comprises an outer wall portion 56, inner wall portion 57, and two first insertion protrusions 58. Each of the first insertion protrusions 58 is an example of second insertion portion. The outer and inner wall portions 56 and 57 and first insertion protrusions 58 are formed integrally with one another. The outer and inner wall portions 56 and 57 may alternatively be formed of separate members.

The outer wall portion 56 is disposed in the recess 41. The outer wall portion 56 extends at right angles to the main board 14, as shown in FIG. 5, and along the lower edge 14d of the main board 14, as shown in FIG. 3. The outer wall portion 56 faces that edge portion of the main board 14 which defines the recess 41. The terminal portions 34 are individually secured to the outer wall portion 56.

The inner wall portion 57 extends continuously from the outer wall portion 56 and faces it. The inner wall portion 57 is formed by, for example, bending a metal plate that forms the outer wall portion 56. The formation of the inner wall portion 57 is not limited to this. If the outer and inner wall portions 56 and 57 are formed of separate members, for example, a part of the inner wall portion 57 may be welded to the central part of the outer wall portion 56. The inner wall portion 57 is located deeper inside the main board 14 than the outer wall portion 56. The distal end of the inner wall portion 57 faces the first surface 14a of the main board 14.

The first insertion protrusions 58 are individually disposed on the distal end of the inner wall portion 57. In other words, the first insertion protrusions 58 are connected to the outer wall portion 56 by the inner wall portion 57. The first insertion protrusions 58 are, for example, prismatic pins and are inserted into their corresponding insertion holes 43. The first insertion protrusions 58 are soldered to the insertion holes 43 so that they are electrically connected to the ground layer 44 and secured to the main board 14.

As shown in FIG. 4, the second sections 52 extend at right angles to the first section 51 at the opposite ends thereof. As shown in FIG. 3, each second section 52 comprises projections 61 and second insertion protrusions 62.

The projections 61 are plate-like portions projecting toward the main board 14. The projections 61 are inserted individually into the slits 42 in the main board 14. As shown in FIG. 5, the projections 61 penetrate the slits 42 so that their respective distal ends project from the second surface 14b of the main board 14.

The second insertion protrusions 62 are prismatic pins projecting toward the main board 14. The second insertion protrusions 62 are inserted into and soldered to their corresponding insertion holes 43. Thus, the second insertion protrusions 62 are electrically connected to the ground layer 44 and secured to the main board 14.

As shown in FIG. 3, the third sections 53 are connected to one another. One end portion of the combination of the connected third sections 53 is secured to an end of one of the second sections 52. The other end portion of the combination of the connected third sections 53 is secured to an end of the other second section 52. In other words, the pair of second sections 52 are connected to each other by the plurality of third sections 53.

Each third section 53, like each second section 52, comprises projections 61 and second insertion protrusions 62. Thus, the second insertion protrusions 62 of the third sections 53 are secured to the main board 14.

The first to third sections 51 to 53 combined in this manner form a frame. The frame-like combination of the first to third sections 51 to 53 surrounds an area where chips 31A and 31B, the coil 32, and the trace pattern are disposed, on the first surface 14a of the main board 14. In other words, the first to third sections 51 to 53 surround the tuner circuit.

A plurality of ridges 64 are disposed on the outer surface of each of the first to third sections 51 to 53. The ridges 64 are located individually at, for example, the respective distal end portions of the projections 61 and end portions opposite the projections 61. The ridges 64 extend longitudinally relative to the first to third sections 51 to 53.

The fourth sections 54 are combined in a lattice shape and secured to the first to third sections 51 to 53. The fourth sections 54 divide the inside of the frame-like combination of the first to third sections 51 to 53 into a plurality of areas. Each of chips 31A and 31B is disposed in each corresponding one of these areas. Areas free from chips 31A and 31B are also provided. Further, chips 31A and 31B may be disposed in each of the areas.

As shown in FIG. 4, the areas for chips 31A are divided from those for chips 31B by two of the fourth sections 54. Alternatively, these areas for chips 31A and 31B may be divided by one of the fourth sections 54. Further, the fourth section or sections 54 for the division may be made thicker than the first to third sections 51 to 53 and the other fourth sections 54.

As shown in FIG. 3, each fourth section 54, like each second section 52, comprises second insertion protrusions 62. Specifically, the second insertion protrusions 62 of the fourth sections 54 are secured to the main board 14.

As shown in FIG. 5, each terminal portion 34 comprises a plug connector portion 66 and connecting terminal 67. The plug connector portion 66 is secured to, for example, a hole in the first section 51 by crimping. The plug connector portion 66 protrudes from the first section 51. The plug connector portion 66 is a columnar structure having a screw thread on its outer peripheral surface. A terminal of an antenna wire is connected to the plug connector portion 66.

The connecting terminal 67 protrudes from each plug connector portion 66. The connecting terminal 67 is electrically connected to the trace pattern on the main board 14 through, for example, a hole in the inner wall portion 57 of the first section 51. The connecting terminal 67 is soldered to the main board 14.

As shown in FIG. 2, two openings 69 corresponding individually to the two connecting terminals 67 are formed in the lower end portion of the rear cover 17. The plug connector portions 66 project to the outside of the housing 11 through the openings 69, individually. In other words, the plug connector portions 66 are exposed.

As shown in FIG. 3, the shield unit 33 comprises extending portions 71. The extending portions 71 are formed by, for example, bending metal plates that form the second sections 52. The formation of the extending portions 71 is not limited to this. For example, the extending portions 71 may be formed integrally with the first section 51 or formed of metal plates different from the shield unit 33.

The pair of extending portions 71 extend individually from the opposite ends of the first section 51. In other words, as shown in FIG. 4, the extending portions 71 and first section 51 are arranged in a straight line. Alternatively, however, the extending portions 71 may be deviated from the first section 51.

As shown in FIG. 3, each extending portion 71 comprises a third insertion protrusion 72. The third insertion protrusion 72 is an example of a first insertion portion. The third insertion protrusion 72 is disposed on an end of the extending portion 71. The third insertion protrusion 72 is a prismatic pin projecting toward the main board 14.

The third insertion protrusions 72 are inserted into and soldered to their corresponding insertion holes 43. Thus, the third insertion protrusions 72 are electrically connected to the ground layer 44 and secured to the main board 14.

The first and second shield covers 35 and 36 are attached to the shield unit 33. Each of the shield covers 35 and 36 comprises a plurality of hooks 75. The hooks 75 individually engage the ridges 64 of the first to third sections 51 to 53. Thus, the first and second shield covers 35 and 36 are secured to the shield unit 33.

The first shield cover 35 covers the first surface 14a of the main board 14 that is surrounded by the frame-like combination of the first to third sections 51 to 53. On the other hand, the second shield cover 36 is secured to the projections 61 of the first to third sections 51 to 53 and covers the second surface 14b of the main board 14.

Chips 31A and 31B mounted on the main board 14 are individually surrounded by the shield unit 33 and first and second shield covers 35 and 36. Thus, chips 31A and 31B are isolated from noise from other components, such as the display module 12, by the shield unit 33 and first and second shield covers 35 and 36. Also, chips 31A and 31B are isolated from noise from the terminal portions 34 and the other chips 31A and 31B by the shield unit 33 and shield covers 35 and 36.

The shield unit 33 and first and second shield covers 35 and 36 configured to be absorbed the noise are grounded by the ground layer 44 with the aid of the first, second, and third insertion protrusions 58, 62 and 72.

When the terminal of the antenna wire is connected to each plug connector portion 66, an external force, for example, a torsional force, acts on the plug connector portion 66. The first section 51 to which the plug connector portions 66 are secured is reinforced as the extending portions 71 are secured to the main board 14. Thus, the first section 51 cannot be easily deformed or displaced even if an external force acts on the plug connector portions 66.

According to the television 10 constructed in this manner, the extending portions 71 extending from the ends of the first section 51 are secured to the main board 14, so that the first section 51 cannot be easily deformed or displaced, as described above. Accordingly, application of an external force to the connecting terminals 67 of the terminal portions 34 connected to the main board 14 is suppressed. Thus, junctions between the main board 14 and terminal portions 34 can be prevented from being damaged, so that the reliability of the tuner module 29 is improved.

Since the extending portions 71 are secured to the main board 14, moreover, the spots where the shield unit 33 and main board 14 are secured to each other are increased in number. Thus, if an external force acts on the terminal portions 34, a force applied to the main board 14 can be dispersed.

The third insertion protrusions 72 of the extending portions 71 are inserted into the insertion holes 43 and electrically connected to the ground layer 44. Thus, the connection between the shield unit 33 and ground layer 44 is strengthened, and interference of the tuner module 29 by noise from other components, such as the display module 12, can be suppressed.

Further, the third insertion protrusions 72 of the extending portions 71 serve to discharge noise from the terminal portions 34 to the ground layer 44. Since the noise from the terminal portions 34 is discharged by the extending portions 71 that are located outside the shield unit 33, the first and second insertion protrusions 58 and 62 inside the shield unit 33 can be reduced in number. Thus, restrictions on the design (position regulation) of the shield unit 33 can be mitigated so that the space occupancy of the shield unit 33 can be reduced, for example.

The third insertion protrusions 72 of the extending portions 71 are secured to the main board 14 by soldering. Thus, electrical connection between the third insertion protrusions 72 and ground layer 44 can be ensured the moment the extending portions 71 are secured to the main board 14. Consequently, work processes for the manufacture of the television 10 can be prevented from increasing in number.

The first insertion protrusions 58 are connected to the outer wall portion 56 of the first section 51. Thus, noise from the terminal portions 34 can be efficiently discharged to the ground layer 44 through the first insertion protrusions 58.

The first section 51 comprises the inner wall portion 57 that extends continuously from the outer wall portion 56 and faces it. Thus, the rigidity of the first section 51 is improved, so that the junctions between the main board 14 and terminal portions 34 can be prevented from being damaged. Further, the noise shielding capability of the first section 51 is improved.

Chips 31A and 31B can be isolated from noise by the single shield unit 33. Thus, an increase in parts count can be suppressed, so that the manufacturing cost of the television 10 can be reduced.

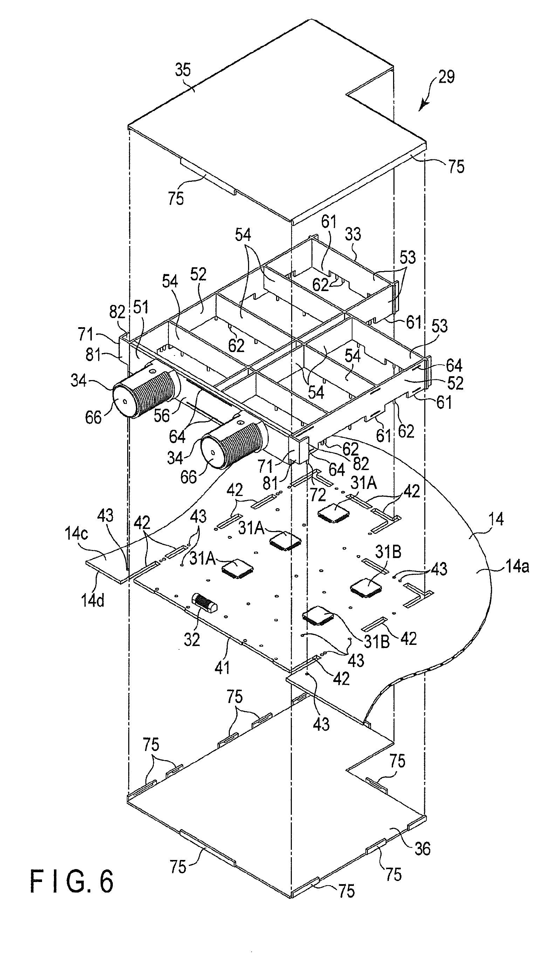

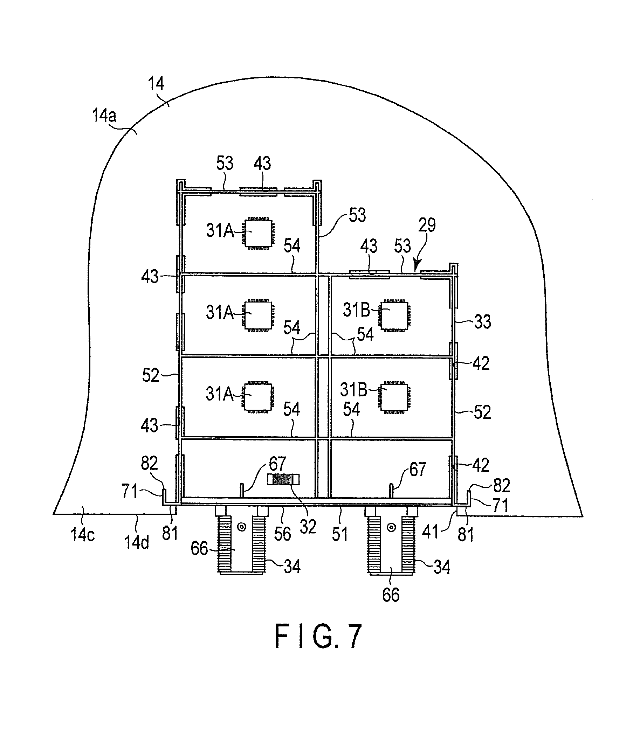

A second embodiment will now be described with reference to FIGS. 6 and 7. In the description of at least one of the embodiments to follow, like reference numbers are used to designate like constituent parts having the same functions as those of the television 10 of the first embodiment. Further, a description of those constituent parts may be partially or entirely omitted.

FIG. 6 is an exemplary exploded perspective view showing a part of a main board 14 and a tuner module 29 according to the second embodiment. FIG. 7 is an exemplary plan view showing a part of the main board 14 and the tuner module 29 with its first shield cover 35 removed.

As shown in FIG. 6, each of extending portions 71 of the second embodiment comprises a proximal portion 81 and intersecting portion 82. The proximal portion 81 and intersecting portion 82 are formed by bending a metal plate that forms the extending portion 71.

The proximal portion 81 extends along the first section 51. The intersecting portion 82 extends at right angles to the proximal portion 81 from an end thereof. In other words, the proximal portion 81 extends along a lower edge 14d of the main board 14, while the intersecting portion 82 extends inwardly relative to the main board 14. A third insertion protrusion 72 is disposed on an end of the intersecting portion 82. The proximal portion 81 and intersecting portion 82 may be arranged at an angle other than 90° to each other.

According to the television 10 constructed in this manner, each extending portion 71 comprises the proximal portion 81 and intersecting portion 82 that extend across each other. Thus, the rigidity of the extending portions 71 and first section 51 is improved, so that junctions between the main board 14 and terminal portions 34 can be prevented from being damaged.

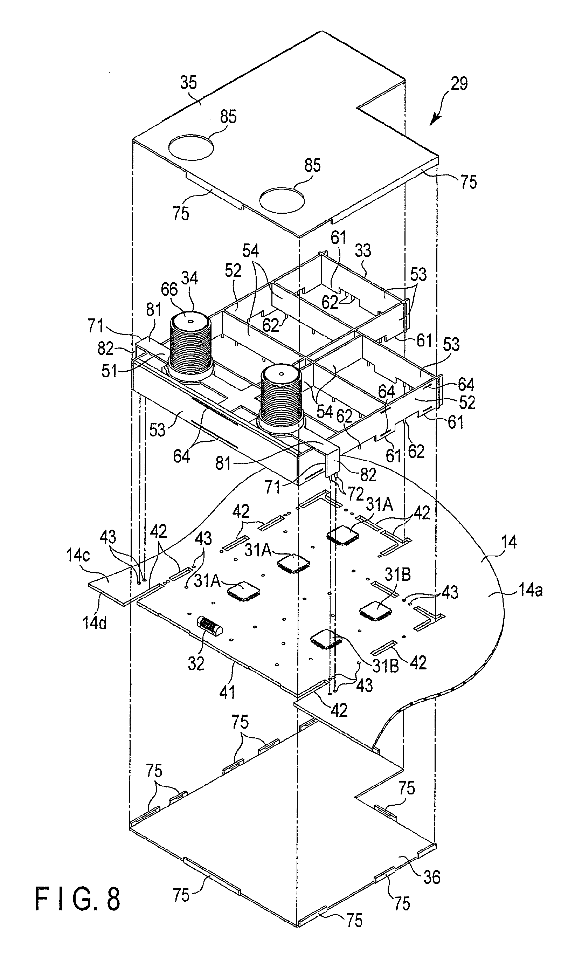

A third embodiment will now be described with reference to FIG. 8. FIG. 8 is an exemplary exploded perspective view showing a part of a main board 14 and a tuner module 29 according to the third embodiment.

In a shield unit 33, as shown in FIG. 8, a plurality of third sections 53 individually connect the respective opposite ends of a pair of second sections 52. Specifically, the second and third sections 52 and 53 form a frame.

A first section 51 is disposed ranging from one of the second sections 52 to the other. The first section 51 faces a first surface 14a of the main board 14. Thus, plug connector portions 66 of terminal portions 34 project at right angles to the first surface 14a.

A first shield cover 35 comprises two holes 85 corresponding individually to the plug connector portions 66 of the terminal portions 34. The plug connector portions 66 project to the outside of a housing 11 through the holes 85 and openings 69 in the housing 11. In the third embodiment, the openings 69 are disposed in the back of the housing 11.

In the third embodiment, extending portions 71 are formed integrally with the first section 51. A proximal portion 81 of each extending portion 71 extends continuously from an end of the first section 51. An intersecting portion 82 extends from an end of the proximal portion 81 toward the main board 14. Third insertion protrusions 72 are disposed on an end of the intersecting portion 82.

In the television 10 of the third embodiment constructed in this manner, as in the television 10 of the first embodiment, the extending portions 71 keep the first section 51 from being easily deformed or displaced. Thus, junctions between the main board 14 and terminal portions 34 can be prevented from being damaged.

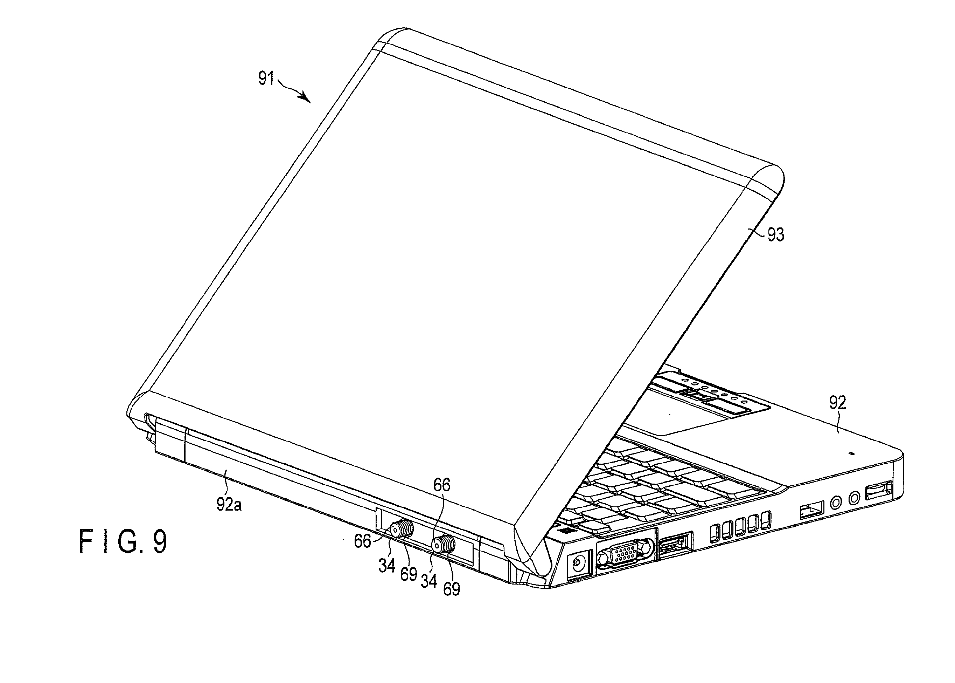

A fourth embodiment will now be described with reference to FIG. 9. FIG. 9 is an exemplary perspective view showing a portable computer 91 according to the fourth embodiment. The portable computer 91 comprises a main unit 92 and display unit 93. The portable computer 91 is an example of a television reception apparatus or electronic apparatus.

The main unit 92 comprises a main board 14 provided with a tuner module 29. As shown in FIG. 9, openings 69 are formed in a rear end portion 92a of the main unit 92. Plug connector portions 66 of terminal portions 34 project from the openings 69, individually.

The main board 14 of the portable computer 91 functions in the same manner as that described in connection with the first embodiment. Specifically, the television reception apparatus or electronic apparatus is not limited to a television 10 and may be one of various apparatuses, including a DVD/BD recorder, HDD recorder, cellphone, smartphone, game console, car navigation system, and external connection system connected to a personal computer, as well as the portable computer 91.

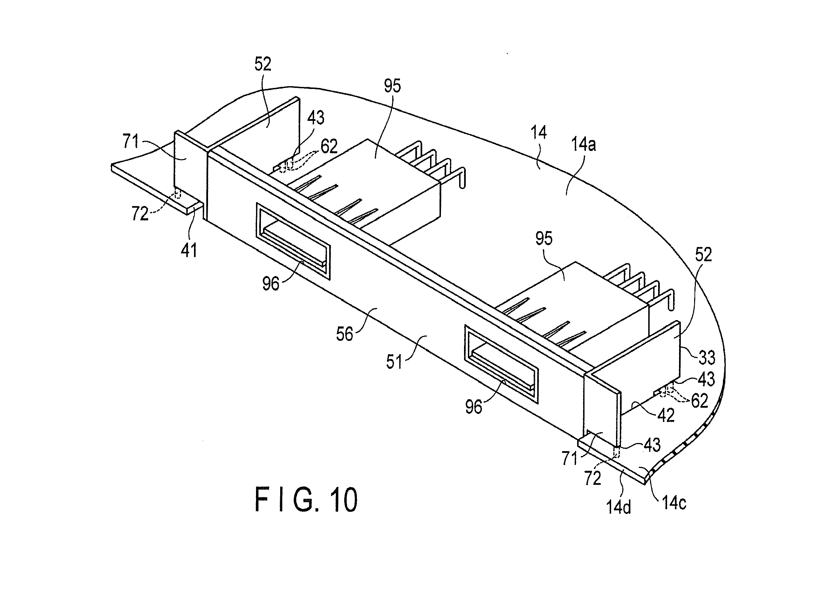

A fifth embodiment will now be described with reference to FIG. 10. FIG. 10 is an exemplary perspective view showing a part of a main board 14 according to the fifth embodiment. As shown in FIG. 10, a television 10 of the fifth embodiment comprises the main board 14, a shield unit 33, and two connectors 95.

For example, terminals of USB cables can be inserted into the connectors 95. Alternatively, the connectors 95 may be configured to be inserted terminals of HDMI cables or other terminals. The connectors 95 are individually mounted on a first surface 14a of the main board 14.

The shield unit 33 comprises a first section 51 and a pair of second sections 52. The two connectors 95 are individually secured to the first section 51. The connectors 95 are exposed individually through two openings 96 in the first section 51.

The second sections 52 extend at right angles to the first section 51 at the opposite ends thereof. Each second section 52 comprises second insertion protrusions 62. The second insertion protrusions 62 are inserted individually into and soldered to insertion holes 43. Thus, the second sections 52 are secured to the main board 14.

The shield unit 33 comprises a pair of extending portions 71. The extending portions 71 extend individually from the opposite ends of the first section 51. Each extending portion 71 comprises a third insertion protrusion 72. The third insertion protrusion 72 is inserted into and soldered to its corresponding insertion hole 43. Thus, the extending portions 71 are secured to the main board 14.

According to the television 10 constructed in this manner, the extending portions 71 extending from the ends of the first section 51 are secured to the main board 14. Therefore, as in the case of the first embodiment, the first section 51 cannot be easily deformed or displaced. Thus, junctions between the connectors 95 and main board 14 can be prevented from being damaged, so that the reliability of the connectors 95 is improved.

Even in the case where the connectors 95 are used in place of the tuner module 29, as described above, the junctions between the connectors 95 and main board 14 can be prevented from being damaged, as in the first embodiment. Thus, the connector means is not limited to the tuner module 29 and may be various other connectors, such as the connectors 95, card slots, and earphone jacks.

According to the television reception apparatus, board module, and/or electronic apparatus described above, the extending portions extending from the end of the first section of the shield unit are secured to the board. Thus, the junctions between the main board and the terminal portions or connectors secured to the first section can be prevented from being damaged.

## Claims

1. A television reception apparatus (10) **characterized by** comprising:
a housing (11) comprising an opening (69);
a board (14) in the housing (11);
an electrically conductive shield unit (33) comprising a first section (51), a pair of second sections (52) intersecting the first section (51) at opposite end portions of the first section (51) and configured to be secured to the board (14), and a third section (53) connecting the pair of second sections (52);
a module unit (29) comprising a circuit unit (31A, 31B, 32) disposed in the board (14) and surrounded by the first to third sections (51, 52, 53) of the shield unit (33) and a terminal portion (34) electrically connected to the circuit unit (31A, 31B, 32), configured to be secured to the first section (51) of the shield unit (33), and exposed through the opening (69) of the housing (11); and
an extending portion (71) extending from one of the end portions of the first section (51) of the shield unit (33) and configured to be secured to the board (14).

2. The television reception apparatus (10) of Claim 1, **characterized in that** the module unit (29) comprises a tuner (29).

3. The television reception apparatus (10) of Claim 2, **characterized in that** the board (14) comprises a ground portion (44) and an insertion hole (43) electrically connected to the ground portion (44), and the extending portion (71) comprises a first insertion portion (72) disposed in the insertion hole (43) and electrically connected to the ground portion (44).

4. The television reception apparatus (10) of Claim 3, **characterized in that** the extending portion (71) is configured to be secured to the board (14) with the first insertion portion (72) soldered to the insertion hole (43).

5. The television reception apparatus (10) of Claim 4, **characterized in that** the extending portion (71) comprises a proximal portion (81) extending along the first section (51) and an intersecting portion (82) intersecting the proximal portion (81) and comprising the first insertion portion (72).

6. The television reception apparatus (10) of Claim 5, **characterized in that** the first section (51) of the shield unit (33) comprises an outer wall portion (56) to which the terminal portion (34) of the module unit (29) is configured to be secured and a second insertion portion (58) connected to the outer wall portion (56), disposed in the insertion hole (43) of the board (14), and electrically connected to the ground portion (44).

7. The television reception apparatus (10) of Claim 6, **characterized in that** the first section (51) of the shield unit (33) comprises an inner wall portion (57) continuous with the outer wall portion (56) and opposed to the outer wall portion (56), and the second insertion portion (58) is disposed on the inner wall portion (57) and connected to the outer wall portion (56) by the inner wall portion (57).

8. A board module (14) **characterized by** comprising:
a board (14);
an electrically conductive shield unit (33) comprising a first section (51), a pair of second sections (52) intersecting the first section (51) at opposite end portions of the first section (51) and configured to be secured to the board (14), and a third section (53) connecting the pair of second sections (52);
a module unit (29) comprising a circuit unit (31A, 31B, 32) disposed in the board (14) and surrounded by the first to third sections (51, 52, 53) of the shield unit (33) and a terminal portion (34) electrically connected to the circuit unit (31A, 31B, 32) and configured to be secured to the first section (51) of the shield unit (33); and
an extending portion (71) extending from one of the end portions of the first section (51) of the shield unit (33) and configured to be secured to the board (14).

9. An electronic apparatus (10) **characterized by** comprising:
a housing (11) comprising an opening (69);
a board (14) in the housing (11);
an electrically conductive shield unit (33) comprising a first section (51) and a second section (52) intersecting the first section (51) at an end portion of the first section (51) and configured to be secured to the board (14);
a connector (95) on the board (14), configured to be secured to the first section (51) of the shield unit (33) and exposed through the opening (69) of the housing (11); and
an extending portion (71) extending from the end portion of the first section (51) of the shield unit (33) and configured to be secured to the board (14).
